# FASCICULE DE BREVET EUROPEEN

(11) **EP 4 042 482 B1**
(45) Date de publication et mention de la délivrance du brevet: **21.05.2025**
(21) Numéro de dépôt: 20780223.2
(22) Date de dépôt: 01.10.2020
(51) Int. Cl.: H01L 27/15, H01L 33/50

(54) **PROCEDE DE FABRICATION D'UN DISPOSITIF OPTOELECTRONIQUE**
VERFAHREN ZUR HERSTELLUNG EINER OPTOELEKTRONISCHEN VORRICHTUNG
METHOD FOR PRODUCING AN OPTOELECTRONIC DEVICE

(30) Priorité: 08.10.2019 FR 1911133
(43) Date de publication de la demande: 17.08.2022
(73) Titulaire: Aledia, 38130 Echirolles (FR)
(72) Inventeur: BOISTARD, Maxime, 38100 GRENOBLE (FR); GIBERT, Philippe, 38960 SAINT ETIENNE DE CROSSEY (FR); MAYER, Frédéric, 38500 VOIRON (FR); POURQUIER, Eric, 38000 GRENOBLE (FR); SCARINGELLA, Sylvia, 38330 MONTBONNOT SAINT MARTIN (FR); TALLET, Clémence, 38120 SAINT EGREVE (FR)
(74) Mandataire: Cabinet Beaumont
(86) Numéro de dépôt international: PCT/EP2020/077472
(87) Numéro de publication internationale: WO 2021/069288

(56) Documents cités:
- WO-A1-2018/002485
- US-A1- 2018 047 880

## Description

La présente demande de brevet revendique la priorité de la demande de brevet français FR19/11133.

### Domaine technique

La présente description concerne de façon générale les dispositifs optoélectroniques comprenant des éléments tridimensionnels semiconducteurs de taille nanométrique ou micrométrique, notamment des microfils ou nanofils ou des structures de forme pyramidale, formant des diodes électroluminescentes et des blocs photoluminescents recouvrant ces diodes électroluminescentes.

### Technique antérieure

Par dispositifs optoélectroniques, on entend des dispositifs adaptés pour effectuer la conversion d'un signal électrique en un rayonnement électromagnétique ou inversement, et notamment des dispositifs dédiés à la détection, la mesure ou l'émission d'un rayonnement électromagnétique. Des dispositifs optoélectroniques à éléments tridimensionnels semiconducteurs peuvent comprendre des diodes électroluminescentes recouvertes de blocs photoluminescents.

Un procédé de fabrication de tels dispositifs optoélectroniques comprend la formation des diodes électroluminescentes sur un substrat et la formation des blocs photoluminescents recouvrant les diodes électroluminescentes. Les blocs photoluminescents peuvent être formés par le dépôt d'une couche photoluminescente sur l'ensemble des diodes électroluminescentes et la gravure de cette couche photoluminescente pour délimiter les blocs photoluminescents.

La délimitation des blocs photoluminescents dans la couche photoluminescente peut comprendre le dépôt d'une couche de résine recouvrant la couche photoluminescente et la délimitation de portions de cette couche photoluminescente par des procédés de photolithographie aux emplacements souhaités des blocs photoluminescents. Les procédés de photolithographie utilisent généralement la détection de marques d'alignement visibles sur le substrat pour placer correctement les masques utilisés pour l'exposition de la couche de résine avec les diodes électroluminescentes.

Un inconvénient d'un tel procédé est que la couche photoluminescente peut être partiellement opaque à la lumière visible, de sorte que les procédés de lithographie utilisant la détection de marques d'alignement peuvent être difficiles à mettre en oeuvre.

Les documents WO 2018/002485 A1 et US 2018/047880 A1 décrivent des procédés de fabrication d'un dispositif optoélectronique.

### Résumé de l'invention

Ainsi, un objet d'un mode de réalisation est de pallier au moins en partie les inconvénients des procédés décrits précédemment de fabrication de dispositifs optoélectroniques à diodes électroluminescentes et à blocs photoluminescents.

Un autre objet d'un mode de réalisation est que les matériaux composant les blocs photoluminescents peuvent ne pas être des matériaux photosensibles adaptés à une utilisation dans des étapes de photolithographie.

Un autre objet d'un mode de réalisation est que le rapport entre la hauteur et la largeur des blocs photoluminescents peut être important.

Un autre objet d'un mode de réalisation est que les dispositifs optoélectroniques puissent être formés à une échelle industrielle et à bas coût.

Un mode de réalisation prévoit un procédé de fabrication d'un dispositif optoélectronique comprenant des ensembles de diodes électroluminescentes dont des premiers et deuxièmes ensembles et des premiers blocs en un premier matériau photoluminescent recouvrant chacun l'un des premiers ensembles. Le procédé comprend la formation d'une couche recouvrant les premiers et deuxièmes ensembles, la délimitation de premières ouvertures dans la couche pour exposer les premiers ensembles, le remplissage des premières ouvertures du premier matériau et la réalisation d'un polissage mécano-chimique pour délimiter les premiers blocs.

Le dispositif comprend des deuxièmes blocs en un deuxième matériau photoluminescent, différent du premier matériau photoluminescent, recouvrant chacun l'un des deuxièmes ensembles, le procédé comprenant la délimitation de deuxièmes ouvertures dans la couche pour exposer les deuxièmes ensembles, le remplissage des deuxièmes ouvertures du deuxième matériau et la réalisation d'un polissage mécano-chimique pour délimiter les deuxièmes blocs.

Selon un mode de réalisation, le dispositif comprend en outre des troisièmes ensembles de diodes électroluminescentes et des troisièmes blocs en un troisième matériau photoluminescent, différent des premier et deuxième matériaux photoluminescents, recouvrant chacun l'un des troisièmes ensembles, la délimitation de troisièmes ouvertures dans la couche pour exposer les troisièmes ensembles, le remplissage des troisièmes ouvertures du troisième matériau et la réalisation d'un polissage mécano-chimique pour délimiter les troisièmes blocs.

Selon un mode de réalisation, le dispositif comprend en outre des quatrièmes ensembles de diodes électroluminescentes, le procédé comprenant la délimitation de quatrièmes blocs dans la couche recouvrant chacun l'un des quatrièmes ensembles de diodes électroluminescentes.

Selon un mode de réalisation, la couche est au moins partiellement transparente au rayonnement émis par les diodes électroluminescentes des quatrièmes ensembles de diodes électroluminescentes.

Selon un mode de réalisation, le procédé comprend la délimitation de quatrièmes ouvertures dans la couche entre les ensembles et la formation de murs aux parois réfléchissantes dans les quatrièmes ouvertures.

Selon un mode de réalisation, le procédé comprend le dépôt d'un revêtement réfléchissant dans les quatrièmes ouvertures et le remplissage du reste des quatrièmes ouvertures par un cinquième matériau.

Selon un mode de réalisation, les murs sont formés après les premiers blocs photoluminescents.

Selon un mode de réalisation, le procédé comprend la formation d'une couche barrière s'étendant dans les quatrièmes ouvertures et recouvrant les premiers blocs photoluminescents avant la formation des murs.

Selon un mode de réalisation, les murs sont formés après les premiers et deuxièmes blocs photoluminescents.

Selon un mode de réalisation, les murs sont formés avant les premiers et deuxièmes blocs photoluminescents.

Selon un mode de réalisation, le procédé comprend la gravure de la couche présente entre les premiers, deuxièmes et troisièmes blocs photoluminescents, la formation d'une couche barrière s'étendant dans les quatrièmes ouvertures et recouvrant les premiers, deuxièmes et troisièmes blocs photoluminescents avant la formation des murs et la formation des murs dans les espaces présents entre les premiers, deuxièmes et troisièmes blocs photoluminescents.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif optoélectronique à diodes électroluminescentes et à blocs photoluminescents ;
la figure 2 est une vue en coupe, partielle et schématique, d'un mode de réalisation d'une diode électroluminescente ;
la figure 3 est une vue en coupe de la structure obtenue à une étape d'un mode de réalisation d'un procédé de fabrication du dispositif de la figure 1 ;
la figure 4 est une vue en coupe de la structure obtenue à une autre étape du procédé ;
la figure 5 est une vue en coupe de la structure obtenue à une autre étape du procédé ;
la figure 6 est une vue en coupe de la structure obtenue à une autre étape du procédé ;
la figure 7 est une vue en coupe de la structure obtenue à une autre étape du procédé ;
la figure 8 est une vue en coupe de la structure obtenue à une autre étape du procédé ;
la figure 9 est une vue en coupe de la structure obtenue à une autre étape du procédé ;
la figure 10 est une vue en coupe de la structure obtenue à une autre étape du procédé ;
la figure 11 est une vue en coupe de la structure obtenue à une autre étape du procédé ;
la figure 12 est une vue en coupe de la structure obtenue à une autre étape du procédé ;
la figure 13 est une vue en coupe de la structure obtenue à une autre étape du procédé ;
la figure 14 est une vue en coupe de la structure obtenue à une autre étape du procédé ;
la figure 15 est une vue en coupe de la structure obtenue à une étape d'un autre mode de réalisation d'un procédé de fabrication du dispositif de la figure 1 ;
la figure 16 est une vue en coupe de la structure obtenue à une autre étape du procédé ;
la figure 17 est une vue en coupe de la structure obtenue à une autre étape du procédé ;
la figure 18 est une vue en coupe de la structure obtenue à une autre étape du procédé ;
la figure 19 est une vue en coupe de la structure obtenue à une autre étape du procédé ;
la figure 20 est une vue en coupe de la structure obtenue à une autre étape du procédé ;
la figure 21 est une vue en coupe de la structure obtenue à une autre étape du procédé ;
la figure 22 est une vue en coupe de la structure obtenue à une autre étape du procédé ;
la figure 23 est une vue en coupe de la structure obtenue à une autre étape du procédé ;
la figure 24 est une vue en coupe de la structure obtenue à une autre étape du procédé ;
la figure 25 est une vue en coupe de la structure obtenue à une autre étape du procédé ;
la figure 26 est une vue en coupe de la structure obtenue à une autre étape du procédé ;
la figure 27 est une vue en coupe de la structure obtenue à une autre étape du procédé ;
la figure 28 est une vue en coupe de la structure obtenue à une étape d'un autre mode de réalisation d'un procédé de fabrication du dispositif de la figure 1 ;
la figure 29 est une vue en coupe de la structure obtenue à une autre étape du procédé ;
la figure 30 est une vue en coupe de la structure obtenue à une autre étape du procédé ;
la figure 31 est une vue en coupe de la structure obtenue à une autre étape du procédé ;
la figure 32 est une vue en coupe de la structure obtenue à une étape d'un autre mode de réalisation d'un procédé de fabrication du dispositif de la figure 1 ;
la figure 33 est une vue en coupe de la structure obtenue à une autre étape du procédé ;
la figure 34 est une vue en coupe de la structure obtenue à une autre étape du procédé ;
la figure 35 est une vue en coupe de la structure obtenue à une autre étape du procédé ;
la figure 36 est une vue en coupe de la structure obtenue à une autre étape du procédé ;
la figure 37 est une vue en coupe de la structure obtenue à une autre étape du procédé ;
la figure 38 est une vue en coupe de la structure obtenue à une autre étape du procédé ;
la figure 39 est une vue en coupe de la structure obtenue à une autre étape du procédé ;
la figure 40 est une vue en coupe de la structure obtenue à une étape d'un autre mode de réalisation d'un procédé de fabrication du dispositif de la figure 1 ;
la figure 41 est une vue en coupe de la structure obtenue à une autre étape du procédé ;
la figure 42 est une vue en coupe de la structure obtenue à une autre étape du procédé ;
la figure 43 est une vue en coupe de la structure obtenue à une autre étape du procédé ;
la figure 44 est une vue en coupe de la structure obtenue à une autre étape du procédé ;
la figure 45 est une vue en coupe de la structure obtenue à une autre étape du procédé ;
la figure 46 est une vue en coupe de la structure obtenue à une autre étape du procédé ;
la figure 47 est une vue en coupe de la structure obtenue à une autre étape du procédé ;
la figure 48 est une vue en coupe de la structure obtenue à une autre étape du procédé ;
la figure 49 est une vue en coupe de la structure obtenue à une autre étape du procédé ;
la figure 50 est une vue en coupe de la structure obtenue à une autre étape du procédé ;
la figure 51 est une vue en coupe de la structure obtenue à une autre étape du procédé ; et
la figure 52 est une vue en coupe de la structure obtenue à une autre étape du procédé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation. Sauf précision contraire, les expressions "environ", "approximativement", "sensiblement", et "de l'ordre de" signifient à 10 % près, de préférence à 5 % près. Lorsque les expressions "environ", "approximativement", "sensiblement", et "de l'ordre de" sont utilisées en relation avec des directions, elles signifient à 10 ° près, de préférence à 5 ° près. En outre, on considère ici que les termes "isolant" et "conducteur" signifient respectivement "isolant électriquement" et "conducteur électriquement".

La transmittance d'une couche correspond au rapport entre l'intensité du rayonnement sortant de la couche par une face de sortie et l'intensité du rayonnement entrant dans la couche par une face d'entrée opposée à la face de sortie. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %. Dans la suite de la description, on appelle lumière visible un rayonnement électromagnétique dont la longueur d'onde est comprise entre 400 nm et 700 nm.

Dans la suite de la description, un film ou une couche est dit étanche à l'oxygène lorsque la perméabilité du film ou de la couche à l'oxygène à 40 °C est inférieure à 1.10⁻¹cm³/(m²*jour*atm). La perméabilité à l'oxygène peut être mesurée selon la méthode ASTM D3985 intitulée "Standard Test Method for Oxygen Gas Transmission Rate Through Plastic Film and Sheeting Using a Coulometric Sensor". Dans la suite de la description, un film ou une couche est dit étanche à l'eau lorsque la perméabilité du film ou de la couche à l'eau à 40 °C est inférieure à 1.10⁻¹g/(m²*jour). La perméabilité à l'eau peut être mesurée selon la méthode ASTM F1249 intitulée "Standard Test Method for Water Vapor Transmission Rate Through Plastic Film and Sheeting Using a Modulated Infrared Sensor".

La présente invention concerne la fabrication de dispositifs optoélectroniques comprenant diodes électroluminescentes formées à partir d'éléments tridimensionnels de taille nanométrique ou micrométrique, en particulier des microfils, des nanofils ou des pyramides.

Le terme "microfil" ou "nanofil" désigne une structure tridimensionnelle de forme allongée selon une direction privilégiée dont au moins deux dimensions, appelées dimensions mineures, sont comprises entre 5 nm et 5 µm, de préférence entre 100 nm et 2 µm, plus préférentiellement entre 200 nm et 1,5 µm, la troisième dimension, appelée dimension majeure ou hauteur, étant supérieure ou égale à 1 fois, de préférence supérieure ou égale à 3 fois et encore plus préférentiellement supérieure ou égale à 5 fois, la plus grande des dimensions mineures. Dans certains modes de réalisation, la hauteur de chaque microfil ou nanofil peut être supérieure ou égale à 500 nm, de préférence comprise entre 1 µm et 50 µm. Dans la suite de la description, on utilise le terme "fil" pour signifier "microfil ou nanofil".

La section droite des fils peut avoir différentes formes, par exemple, une forme ovale, circulaire ou polygonale, notamment triangulaire, rectangulaire, carrée ou hexagonale. On comprendra que le terme "diamètre moyen" utilisé en relation avec une section droite d'un fil désigne une quantité associée avec l'aire du fil dans cette section droite, correspondant, par exemple, au diamètre du disque ayant la même aire que la section droite du fil.

Dans la suite de la description, le terme pyramide désigne une structure tridimensionnelle dont une partie est de forme pyramidale ou conique allongée. Cette structure pyramidale peut être tronquée, c'est-à-dire que le haut du cône est absent, laissant place à un plateau. La base de la pyramide est inscrite dans un carré dont la dimension des côtés est de 100 nm à 10 µm, préférentiellement entre 0,2 µm et 2 µm. Le polygone formant la base de la pyramide peut être un hexagone. La hauteur de la pyramide entre la base de la pyramide et le sommet ou le plateau sommital varie de 100 nm à 20 µm, préférentiellement entre 200 nm et 2 µm.

Dans la suite de la description, des modes de réalisation vont être décrits dans le cas d'un dispositif optoélectronique à diodes électroluminescentes comprenant des microfils ou nanofils. Toutefois, il est clair que ces modes de réalisation peuvent concerner un dispositif optoélectronique à diodes électroluminescentes comprenant des pyramides de taille micrométrique ou nanométrique.

Les fils comprennent en majorité, de préférence à plus de 60 % en masse, plus préférentiellement à plus de 80 % en masse, au moins un matériau semiconducteur. Le matériau semiconducteur peut être du silicium, du germanium, du carbure de silicium, un composé III-V, un composé II-VI ou une combinaison d'au moins deux de ces composés.

Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires. Le matériau semiconducteur des fils peut comporter un dopant, par exemple du silicium assurant un dopage de type N d'un composé III-N, ou du magnésium assurant un dopage de type P d'un composé III-N.

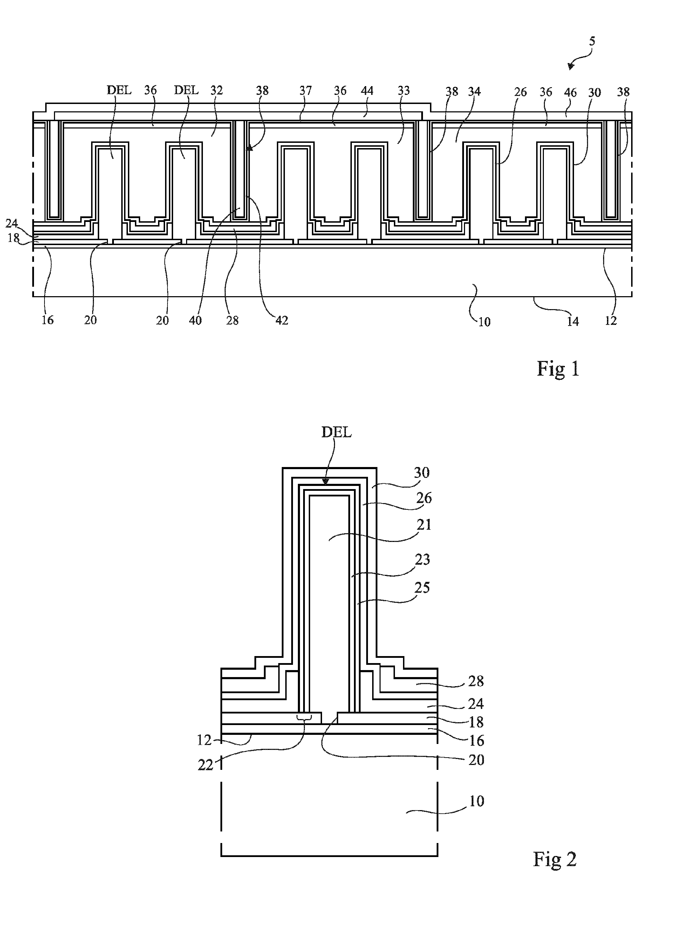

La figure 1 est une vue en coupe, partielle et schématique, d'un mode de réalisation d'un dispositif optoélectronique 5 à nanofils ou microfils. Le dispositif optoélectronique 5 comprend de bas en haut en figure 1 :
- un substrat 10 comprenant des faces opposées 12 et 14, la face supérieure 12 étant de préférence plane au moins au niveau des diodes électroluminescentes ;
- une couche de germination 16 en un matériau favorisant la croissance de fils et disposée sur la face 12 ;
- une couche isolante 18 recouvrant la couche de germination 16 et comprenant des ouvertures 20 exposant des portions de la couche de germination 16 ;
- des diodes électroluminescentes DEL (six diodes électroluminescentes étant représentées), chaque diode électroluminescente DEL étant en contact avec la couche de germination 16 au travers de l'une des ouvertures 20 ;
- une couche isolante 24 s'étendant sur les flancs latéraux d'une portion inférieure de diode électroluminescente DEL et s'étendant sur la couche isolante 18 entre les diodes électroluminescentes DEL ;
- une couche 26 formant une électrode recouvrant chaque diode électroluminescente DEL et s'étendant en outre sur la couche isolante 24 entre les diodes électroluminescentes DEL ;
- une couche conductrice 28 et réfléchissante, s'étendant sur la couche 26 entre les diodes électroluminescentes DEL, la couche conductrice 28 pouvant, à titre de variante, être interposée entre la couche d'électrode 26 et la couche isolante 24 entre les diodes électroluminescentes DEL ;
- une couche 30 de protection diélectrique s'étendant sur les couches 26 et 28 ;
- des blocs photoluminescents 32, 33 recouvrant certains ensembles de diodes électroluminescentes ;
- des blocs 34 transparents au rayonnement émis par les diodes électroluminescentes et recouvrant d'autres ensembles de diodes électroluminescentes, les blocs transparents 34 pouvant ne pas être présents ;
- une couche isolante 36 recouvrant la face supérieure de chaque bloc 32, 33, 34, ou seulement de certains des blocs 32, 33, 34, la couche isolante 36 pouvant ne pas être présente ;
- une couche de protection 37 recouvrant les couches isolantes 36, les faces latérales des blocs 32, 33, 34 et la couche d'électrode 26 entre les blocs 32, 34 ;
- des murs 38 entre les blocs 32, 34, chaque mur 38 comprenant un coeur 40 entouré d'un revêtement 42 réfléchissant ;
- un, deux ou trois filtres de couleur 44, par exemple un seul filtre jaune, deux filtres, le premier étant un filtre jaune et le deuxième étant un filtre rouge, ou trois filtres, le premier étant un filtre rouge, le deuxième étant un filtre vert et le troisième étant un filtre bleu, recouvrant au moins certains des blocs photoluminescents 32, 33, un seul filtre 44 recouvrant deux blocs étant représentés à titre d'exemple ; et
- une couche de protection 46 recouvrant l'ensemble de la structure.

La figure 2 représente un mode de réalisation des diodes électroluminescentes DEL. Selon un mode de réalisation, chaque diode électroluminescente DEL comprend un fil 21 en contact avec la couche de germination 16 au travers de l'une des ouvertures 20 et une coque 22 comprenant un empilement de couches semiconductrices recouvrant les parois latérales et le sommet du fil 21. L'ensemble formé par chaque fil 21 et la coque 22 associée constitue une diode électroluminescente DEL.

La coque 22 peut comprendre un empilement de plusieurs couches comprenant notamment une couche active 23 et une couche de liaison 25. La couche active 23 est la couche depuis laquelle est émise la majorité du rayonnement fourni par la diode électroluminescente DEL. Selon un exemple, la couche active 23 peut comporter des moyens de confinement, tels que des puits quantiques multiples. La couche de liaison 25 peut comprendre un empilement de couches semiconductrices du même matériau III-V que le fil 21 mais du type de conductivité opposé au fil 21.

Le substrat 10 peut correspondre à une structure monobloc ou correspondre à une couche recouvrant un support constitué d'un autre matériau. Le substrat 10 est de préférence un substrat semiconducteur, par exemple un substrat en silicium, en germanium, en carbure de silicium, en un composé III-V, tel que du GaN ou du GaAs, ou un substrat en ZnO. De préférence, le substrat 10 est un substrat de silicium monocristallin. De préférence, il s'agit d'un substrat semiconducteur compatible avec les procédés de fabrication mis en oeuvre en microélectronique. Le substrat 10 peut correspondre à une structure multicouches de type silicium sur isolant, également appelée SOI (acronyme anglais pour Silicon On Insulator).

La section droite des ouvertures 20 peut correspondre à la section droite souhaitée des fils 21 ou peut être différente de la section droite des fils qui sera obtenue. Le diamètre moyen des fils 21 peut être égal ou supérieur au diamètre moyen des ouvertures 20.

La couche de germination 16 est en un matériau favorisant la croissance des fils. A titre d'exemple, le matériau composant la couche de germination 16 peut être un nitrure, un carbure ou un borure d'un métal de transition de la colonne IV, V ou VI du tableau périodique des éléments ou une combinaison de ces composés. A titre d'exemple, la couche de germination 16 peut être en nitrure d'aluminium (AlN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci. La couche de germination 16 peut avoir une structure monocouche ou correspondre à un empilement d'au moins deux couches, chaque couche étant par exemple dans l'un des matériaux décrits précédemment.

Selon un autre mode de réalisation, la couche de germination 16 peut ne pas être présente. Selon un autre mode de réalisation, la couche de germination 16 peut être remplacée par des plots de germination, par exemple formés au fond des ouvertures 20.

Chaque couche isolante 18, 24, 30, 36, 37, 46 et le matériau de remplissage 40 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'aluminium (Al₂O₃), en oxyde d'hafnium (HfO₂), en dioxyde de titane (TiO₂) ou en diamant. La couche isolante 18, 24, 30, 36, 37, 46 peut avoir une structure monocouche ou correspondre à un empilement de deux couches ou de plus de deux couches. Lorsque la couche isolante 18 correspond à un empilement d'au moins deux couches, la couche supérieure de l'empilement est de type isolante, par exemple en un matériau diélectrique.

La couche conductrice 28 ou le revêtement 42 correspond, de préférence à une couche métallique, par exemple en aluminium, en argent, en cuivre, en or ou en zinc. L'épaisseur de la couche conductrice 28 ou du revêtement 42 peut être comprise entre 0,01 µm et 1000 µm. A titre de variante, le revêtement 42 peut ne pas être présent. Dans ce cas, le matériau de remplissage 40 peut être un matériau métallique, par exemple de l'aluminium, de l'argent, du cuivre ou du zinc.

La couche d'électrode 26 est adaptée à laisser passer le rayonnement électromagnétique émis par les diodes électroluminescentes. Le matériau formant la couche d'électrode 26 peut être un matériau transparent et conducteur tel que de l'oxyde d'indium-étain (ou ITO, acronyme anglais pour Indium Tin Oxide), de l'oxyde de zinc dopé à l'aluminium ou au gallium, ou du graphène. L'épaisseur de la couche d'électrode 26 peut être comprise entre 0,01 µm et 10 µm.

Selon un mode de réalisation, chaque bloc photoluminescent 32, 33 est situé en vis-à-vis de l'une des diodes électroluminescentes ou d'un ensemble de diodes électroluminescentes. Chaque bloc photoluminescent 32, 33 comprend des luminophores adaptés, lorsqu'ils sont excités par la lumière émise par la diode électroluminescente DEL associée, à émettre de la lumière à une longueur d'onde différente de la longueur d'onde de la lumière émise par la diode électroluminescente DEL associée. Selon un mode de réalisation, le dispositif optoélectronique 5 comprend au moins deux types de blocs photoluminescents 32, 33. Chaque bloc photoluminescent 32 du premier type est adapté à convertir le rayonnement fourni par les diodes électroluminescentes qu'il recouvre en un premier rayonnement à une première longueur d'onde et chaque bloc photoluminescent 33 du deuxième type est adapté à convertir le rayonnement fourni par les diodes électroluminescentes qu'il recouvre en un deuxième rayonnement à une deuxième longueur d'onde. Selon un mode de réalisation, le dispositif optoélectronique 5 comprend au moins trois types de blocs photoluminescents 32, 33, chaque bloc photoluminescent du troisième type étant adapté à convertir le rayonnement fourni par les diodes électroluminescentes qu'il recouvre en un troisième rayonnement à une troisième longueur d'onde. Les première, deuxième et troisième longueurs d'ondes peuvent être différentes.

Selon un mode de réalisation, les diodes électroluminescentes sont adaptées à émettre de la lumière bleue, c'est-à-dire un rayonnement dont la longueur d'onde est dans la plage de 430 nm à 480 nm. Selon un mode de réalisation, la première longueur d'onde correspond à de la lumière verte et est dans la plage de 510 nm à 570 nm. Selon un mode de réalisation, la deuxième longueur d'onde correspond à de la lumière rouge et est dans la plage de 600 nm à 720 nm.

Selon un autre mode de réalisation, les diodes électroluminescentes DEL sont par exemple adaptées à émettre un rayonnement dans l'ultraviolet. Selon un mode de réalisation, la première longueur d'onde correspond à de la lumière bleue et est dans la plage de 430 nm à 480 nm. Selon un mode de réalisation, la deuxième longueur d'onde correspond à de la lumière verte et est dans la plage de 510 nm à 570 nm. Selon un mode de réalisation, la troisième longueur d'onde correspond à de la lumière rouge et est dans la plage de 600 nm à 720 nm.

Le rapport d'aspect des blocs 32, 33, c'est-à-dire le rapport entre la hauteur et la largeur maximale du bloc, peut être compris entre 0,01 et 10, de préférence entre 0,05 et 2.

Selon un mode de réalisation, chaque bloc photoluminescent 32, 33 comprend des particules d'au moins un matériau photoluminescent, par exemple dans une matrice transparente. Un exemple d'un matériau photoluminescent est le grenat d'yttrium et d'aluminium (YAG) activé par l'ion cérium trivalent, également appelé YAG:Ce ou YAG:Ce³⁺. La taille moyenne des particules des matériaux photoluminescents classiques est généralement supérieure à 5 µm.

Selon un mode de réalisation, chaque bloc photoluminescent 32, 33 comprend une matrice dans laquelle sont dispersées des particules monocristallines de taille nanométrique d'un matériau semiconducteur, également appelées nanocristaux semiconducteurs ou particules de nanoluminophores par la suite. Le rendement quantique interne QYᵢₙₜ d'un matériau photoluminescent est égal au rapport entre le nombre de photons émis et le nombre de photons absorbés par la substance photoluminescente. Le rendement quantique interne QYᵢₙₜ des nanocristaux semiconducteurs est supérieur à 5 %, de préférence supérieur à 10 %, plus préférentiellement supérieur à 20 %.

Selon un mode de réalisation, la taille moyenne des nanocristaux est dans la plage de 0,5 nm et 1000 nm, de préférence de 0,5 nm à 500 nm, encore plus préférentiellement de 1 nm à 100 nm, notamment de 2 nm à 30 nm. Pour des dimensions inférieures à 50 nm, les propriétés de photoconversion des nanocristaux semiconducteurs dépendent essentiellement de phénomènes de confinement quantique. Les nanocristaux semiconducteurs correspondent alors à des boîtes quantiques.

Selon un mode de réalisation, le matériau semiconducteur des nanocristaux semiconducteurs est choisi parmi le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂), les pérovskites du type PbScX₃, où X est un atome d'halogène, notamment l'iode (I), le brome (Br) ou le chlore (Cl), et un mélange d'au moins deux de ces composés. Selon un mode de réalisation, le matériau semiconducteur des nanocristaux semiconducteurs est choisi parmi les matériaux cités dans la publication au nom de Le Blevenec et al. de Physica Status Solidi (RRL) - Rapid Research Letters Volume 8, No. 4, pages 349-352, avril 2014.

Selon un mode de réalisation, les dimensions des nanocristaux semiconducteurs sont choisies selon la longueur d'onde recherchée du rayonnement émis par les nanocristaux semiconducteurs. A titre d'exemple, des nanocristaux de CdSe dont la taille moyenne est de l'ordre de 3,6 nm sont adaptés à convertir de la lumière bleue en lumière rouge et des nanocristaux de CdSe dont la taille moyenne est de l'ordre de 1,3 nm sont adaptés à convertir de la lumière bleue en lumière verte. Selon un autre mode de réalisation, la composition des nanocristaux semiconducteurs est choisie selon la longueur d'onde recherchée du rayonnement émis par les nanocristaux semiconducteurs.

La matrice est au moins en partie transparente au rayonnement émis par les particules photoluminescentes et/ou les diodes électroluminescentes DEL, de préférence à plus de 80 %. La matrice est, par exemple, en silice. La matrice est, par exemple, en n'importe quel polymère au moins en partie transparent, notamment en silicone, en époxy, en résine acrylique du type poly(méthacrylate de méthyle) (PMMA), ou en acide polyacétique (PLA). La matrice peut notamment être en un polymère au moins en partie transparent utilisé avec les imprimantes tridimensionnelles. La matrice peut correspondre à un verre déposé par centrifugation (SOG, sigle anglais pour Spin On Glass), photosensible ou non photosensible. Selon un mode de réalisation, la matrice contient de 2 % à 90 %, de préférence de 10 % à 60 %, en poids de nanocristaux, par exemple environ 30 % en poids de nanocristaux.

L'épaisseur des blocs photoluminescents 32, 33 dépend de la concentration de nanocristaux et du type de nanocristaux utilisé. La hauteur des blocs photoluminescents 32, 33 est de préférence supérieure à la hauteur des fils 21 et inférieure ou égale à la hauteur des murs 38. En vue de dessus, chaque bloc photoluminescent 32, 33 peut correspondre à un carré, un rectangle, un polygone en forme de "L", etc., dont l'aire peut être égale à l'aire d'un carré ayant un côté mesurant de 1 µm à 100 µm, de préférence de 3 µm à 15 µm.

Les murs 38 sont au moins en partie en au moins un matériau réfléchissant. Le matériau réfléchissant peut être un matériau métallique notamment le fer, le cuivre, l'aluminium, le tungstène, l'argent, le titane, l'hafnium, le zirconium ou une combinaison d'au moins deux de ces composés. De préférence, les murs 38 sont formés en un matériau compatible avec les procédés de fabrication mis en oeuvre en microélectronique. De préférence, les murs 38 sont formés en aluminium ou en argent.

La hauteur des murs 38, mesurée selon une direction perpendiculaire à la face 12, est dans la plage de 300 nm à 200 µm, de préférence de 3 µm à 15 µm. L'épaisseur des murs 38, mesurée selon une direction parallèle à la face 12, est dans la plage de 100 nm à 50 µm, de préférence de 0,5 µm à 10 µm.

Selon un mode de réalisation, les murs 38 peuvent être formés d'un matériau réfléchissant ou recouverts d'un revêtement réfléchissant à la longueur d'onde du rayonnement émis par les blocs photoluminescents 32, 33 et/ou les diodes électroluminescentes.

De préférence, les murs 38 entourent les blocs photoluminescents 32, 33. Les murs 38 réduisent alors la diaphonie entre blocs photoluminescents 32, 33 adjacents.

La couche d'encapsulation 46 est au moins partiellement transparente au rayonnement émis par les particules photoluminescentes et/ou les diodes électroluminescentes DEL. La couche d'encapsulation peut être réalisée en un matériau inorganique au moins partiellement transparent au rayonnement émis par les particules photoluminescentes et/ou les diodes électroluminescentes DEL. A titre d'exemple, le matériau inorganique est choisi parmi le groupe comprenant les oxydes de silicium, du type SiOₓ où x est un nombre réel compris entre 1 et 2 ou SiO_{y}N_{z} où y et z sont des nombres réels compris entre 0 et 1, l'oxyde de titane, les oxydes d'aluminium, par exemple Al₂O₃, et les mélanges de ces composés. La couche d'encapsulation peut être réalisée en un matériau organique au moins partiellement transparent. A titre d'exemple, la couche d'encapsulation est un polymère silicone, un polymère époxyde, un polymère acrylique ou un polycarbonate. La couche d'encapsulation 46 peut avoir une structure monocouche ou multicouches, et comprendre par exemple un empilement de couches organiques et/ou inorganiques.

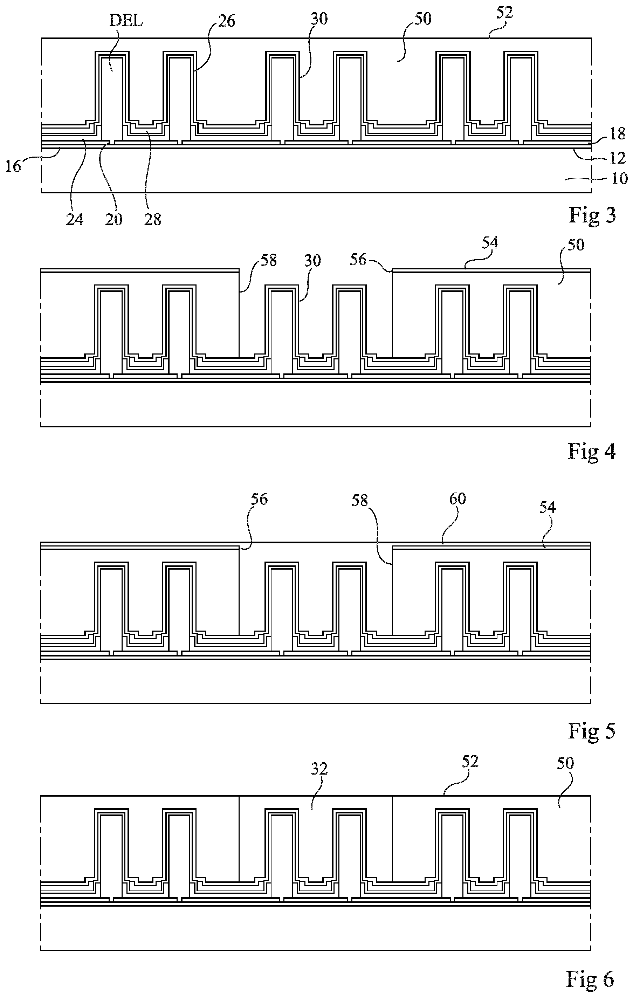

Les figures 3 à 14 illustrent les structures obtenues à des étapes successives d'un mode de réalisation d'un procédé de fabrication du dispositif optoélectronique 5 représenté en figure 1.

La figure 3 illustre la structure obtenue après la formation de la couche de germination 16 sur la face 12 du substrat 10, la formation de la couche isolante 18 sur la couche de germination 16, la gravure des ouvertures 20 dans la couche isolante 18, la formation des diodes électroluminescentes DEL, c'est-à-dire la croissance des fils dans les ouvertures 20, par exemple par dépôt chimique en phase vapeur organométallique (MOCVD, acronyme anglais pour Metal-Organic Chemical Vapor Deposition) ou tout autre procédé adapté, et la formation des coques recouvrant les fils, la formation de la couche isolante 24 au pied de chaque diode électroluminescente DEL , la formation de la couche d'électrode 26, la formation de la couche conductrice 28, la formation de la couche diélectrique 30, et le dépôt d'une couche 50 d'un matériau transparent à la lumière visible notamment un matériau diélectrique, remplissant les espaces entre les fils 21 jusqu'à former une face supérieure 52 sensiblement plane au-dessus de la couche diélectrique 30. La couche 50 peut être en un matériau minéral transparent dans le visible, du SiO₂, du SiN, du Al₂O₃. La couche 50 peut être en résine, notamment en résine photosensible. La couche 50 peut être déposée par dépôt à la tournette, revêtement par filière (en anglais slot-die coating), revêtement à la lame (en anglais blade-coating), flexographie ou sérigraphie.

La figure 4 représente la structure obtenue après le dépôt d'une couche 54, utilisée comme masque de gravure, sur la couche transparente 50 et, à chaque emplacement souhaité d'un bloc photoluminescent 32 du premier type, la gravure d'une ouverture 56 dans la couche 54 et d'une ouverture 58, prolongeant l'ouverture 56, dans la couche transparente 50 sur la totalité de l'épaisseur de la couche transparente 50. La couche 54 peut être dans l'un des matériaux décrits précédemment pour la couche isolante 18, 24, 30, 36, 37, 46. La gravure de la couche isolante 54 peut être une gravure sèche, par exemple du type plasma ionique, ou gravure humide, préférentiellement sélective par rapport au matériau de la couche transparente 50. Dans le cas où la couche 50 est en SiO₂, la couche 54 peut être une résine photosensible et peut être retirée après la réalisation de l'ouverture 58. La gravure de la couche transparente 50 peut être une gravure sèche, par exemple du type plasma ionique, préférentiellement sélective par rapport à la couche de protection 30.

La figure 5 représente la structure obtenue après avoir rempli complètement les ouvertures 56, 58 avec le matériau formant les blocs photoluminescents 32 du premier type. Il peut s'agir d'un dépôt à la tournette ou d'un revêtement par filière. L'étape de remplissage entraîne la formation d'une couche 60 du matériau formant les blocs photoluminescents 32 sur la couche isolante 54.

La figure 6 représente la structure obtenue après une étape de gravure, notamment de polissage mécano-chimique, appelée également CMP (sigle anglais pour Chemical-Mechanical Polishing) pour retirer la couche 60 et la couche isolante 54 de façon à exposer la face supérieure 52 de la couche transparente 50. L'étape de polissage mécano-chimique peut comprendre, simultanément ou successivement, des étapes de polissage mécanique et des étapes de gravure chimique. Selon un mode de réalisation, la couche 60 peut être retirée par CMP, la couche 54 servant alors de couche d'arrêt de gravure. La couche 54 peut ensuite être retirée, par exemple par gravure sèche, notamment une gravure plasma, ou par une gravure humide. Les blocs photoluminescents 32 sont ainsi délimités. A titre de variante, la couche 54 peut ne pas être retirée.

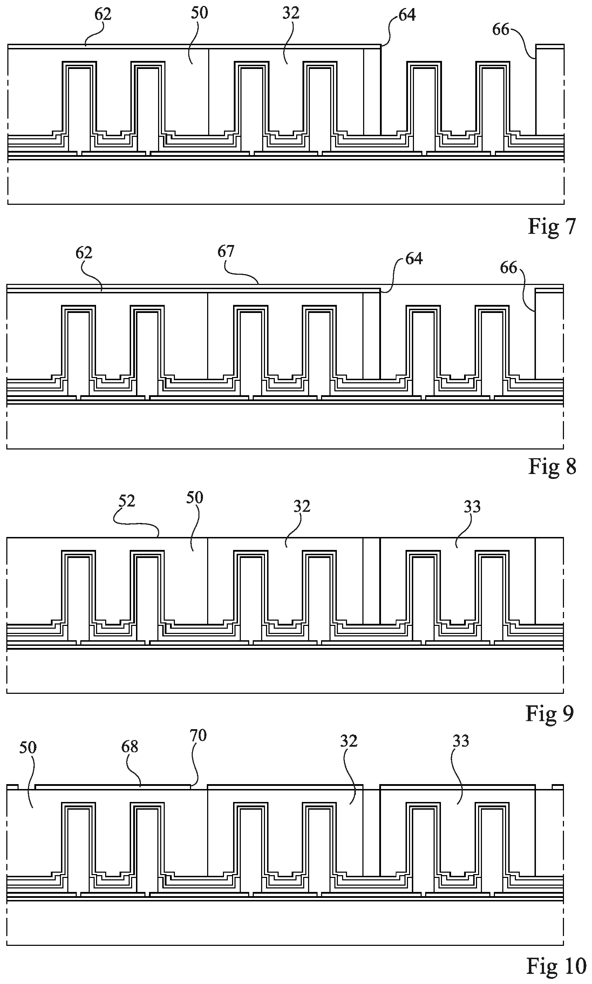

La figure 7 représente la structure obtenue après le dépôt d'une couche 62, utilisée comme masque de gravure, sur la couche transparente 50 et, à chaque emplacement souhaité d'un bloc photoluminescent 33 du deuxième type, la gravure d'une ouverture 64 dans la couche 62 et d'une ouverture 66, prolongeant l'ouverture 64, dans la couche transparente 50 sur la totalité de l'épaisseur de la couche transparente 50. La couche 62 peut être dans l'un des matériaux décrits précédemment pour la couche isolante 18, 24, 30, 36, 37, 46, 56.

La figure 8 représente la structure obtenue après avoir rempli complètement les ouvertures 64, 66 avec le matériau formant les blocs photoluminescents 33 du deuxième type. Il peut s'agir d'un dépôt à la tournette ou d'un revêtement par filière. L'étape de remplissage entraîne la formation d'une couche 67 du matériau formant les blocs photoluminescents 33 sur la couche transparente 50.

La figure 9 représente la structure obtenue après une étape de CMP pour retirer la couche 67 et la couche isolante 62 pour exposer la face supérieure 52 de la couche transparente 50. Les blocs photoluminescents 33 sont ainsi délimités. A titre de variante, la couche 67 peut être retirée par CMP, la couche 62 servant alors de couche d'arrêt de gravure. La couche 62 peut ensuite être retirée, par exemple par gravure sèche, notamment une gravure plasma, ou par une gravure humide. A titre de variante, la couche 62 peut ne pas être retirée.

La figure 10 représente la structure obtenue après le dépôt d'une couche 68, utilisée comme masque de gravure, sur la couche transparente 50 et les blocs photoluminescents 32, 33 et, à chaque emplacement souhaité d'un mur 38, la gravure d'une ouverture 70 dans la couche 68.

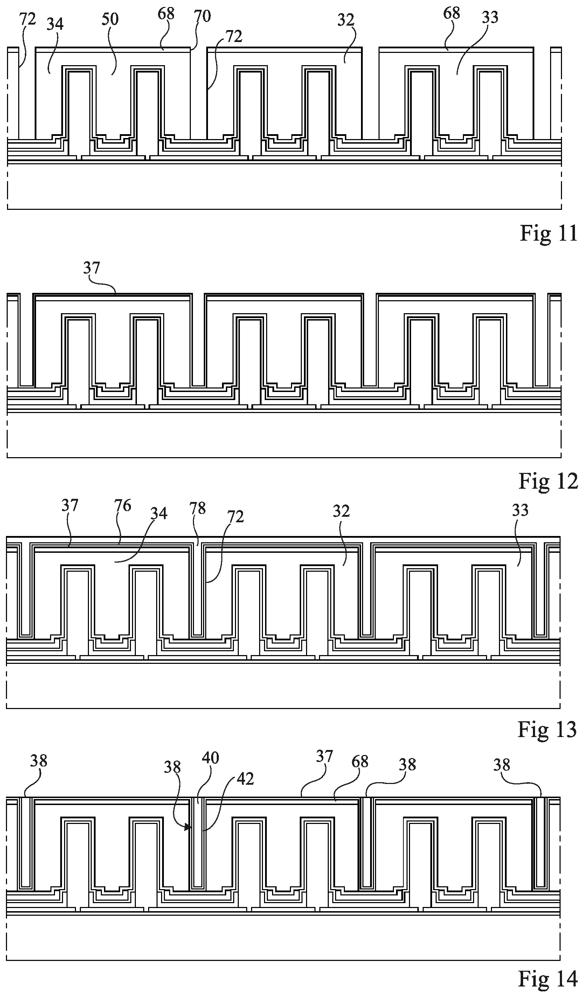

La figure 11 représente la structure obtenue après la gravure, pour chaque ouverture 70, d'une ouverture 72, prolongeant l'ouverture 70, dans la couche transparente 50, sur la totalité de l'épaisseur de la couche transparente 50. La couche 68 peut alors être conservée ou non. Les portions restantes de la couche transparente 50 forment les blocs transparents 34. Dans le cas où la couche 50 est en SiO₂, la couche 68 peut être une couche d'une résine photosensible et peut être retirée après la réalisation de l'ouverture 72.

La figure 12 représente la structure obtenue après le dépôt de la couche isolante 37 sur la totalité de la structure représentée en figure 11. La couche isolante 37 peut être déposée par un procédé de dépôt conforme, notamment un procédé de couches minces atomiques (ALD, sigle anglais pour Atomic Layer Deposition). La couche isolante 37 peut notamment être une couche étanche à l'humidité et/ou à l'air et jouer le rôle de couche de protection pour les blocs photoluminescents 32, 33. De façon avantageuse, la couche 37 est déposée juste après la formation des blocs photoluminescents 32, 33.

La figure 13 représente la structure obtenue après le dépôt, sur la totalité de la structure représentée en figure 12, d'une couche 76 dans le matériau composant les revêtements 42 des murs 38, et après le remplissage des ouvertures 72 par le matériau composant les coeurs 40 des murs 38, ce qui entraîne la formation d'une couche 78 du matériau de remplissage sur les blocs 32, 33, 34.

La figure 14 représente la structure obtenue après une étape de gravure, pour retirer les parties de la couche 78 du matériau de remplissage et les parties de la couche 76 situées en dehors des ouvertures 72 jusqu'à exposer les parties de la couche isolante 37 recouvrant les portions de la couche isolante 68, délimitant ainsi les murs 38, notamment les coeurs 40 et les revêtements 42. A titre d'exemple, les parties de la couche 78 en dehors des ouvertures 72 peuvent être retirées par gravure sèche et les parties de la couche 76 situées en dehors des ouvertures 72 peuvent être retirées par gravure humide ou sèche.

Le procédé comprend des étapes supplémentaires de formation des filtres de couleur 44 et de la couche de protection 46.

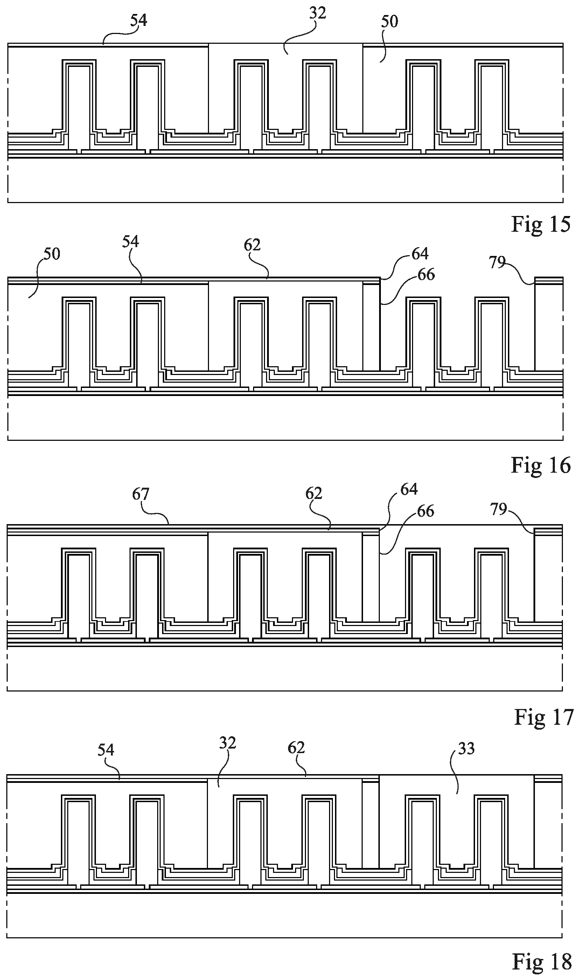

Les figures 15 à 27 illustrent les structures obtenues à des étapes successives d'un autre mode de réalisation d'un procédé de fabrication du dispositif optoélectronique 5.

La figure 15 illustre la structure obtenue après des étapes identiques à celles décrites précédemment en relation avec les figures 3, 4, 5 et 6 à la différence que, à l'étape de CMP, la couche isolante 54 n'est pas retirée.

La figure 16 représente la structure obtenue après le dépôt de la couche 62, utilisée comme masque de gravure, sur l'ensemble de la structure et, à chaque emplacement souhaité d'un bloc photoluminescent 33 du deuxième type, la gravure d'une ouverture 64 dans la couche 62, d'une ouverture 79 dans la couche 54 prolongeant l'ouverture 64 et de l'ouverture 66, prolongeant l'ouverture 64, dans la couche transparente 50 sur la totalité de l'épaisseur de la couche transparente 50.

La figure 17 représente la structure obtenue après des étapes analogues à celles décrites précédemment en relation avec la figure 8, c'est-à-dire après avoir rempli complètement des ouvertures 64, 79, 66 avec le matériau formant les blocs photoluminescents 33 du deuxième type. Il peut s'agir d'un dépôt à la tournette. L'étape de remplissage entraîne la formation de la couche 67 du matériau formant les blocs photoluminescents 33 sur la couche isolante 62.

La figure 18 représente la structure obtenue après une étape de CMP pour retirer la couche 67 jusqu'à atteindre la couche isolante 62 qui n'est pas retirée. Les blocs photoluminescents 33 sont ainsi délimités.

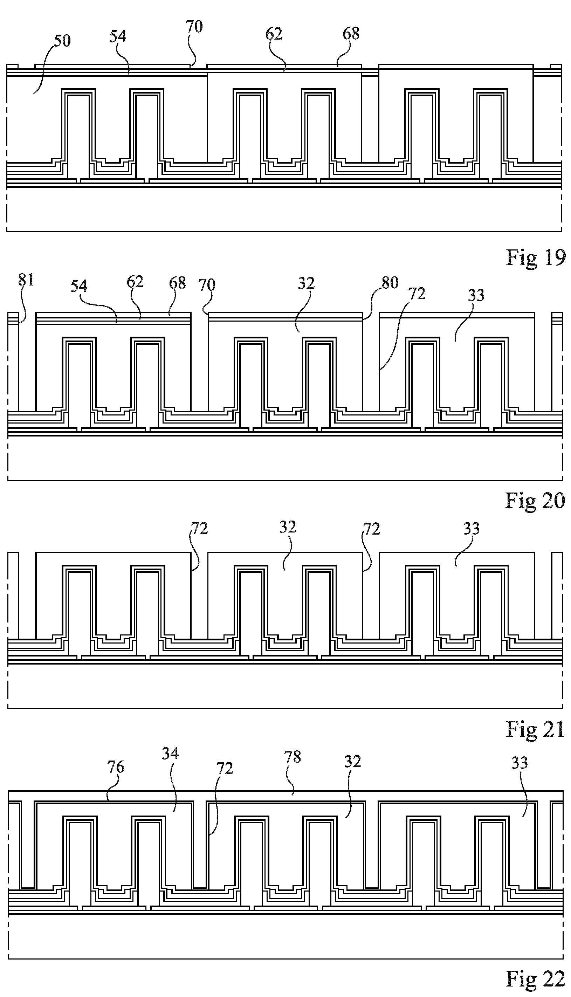

Les figures 19 et 20 illustrent des étapes analogues aux étapes décrites précédemment en relation avec les figures 10 et 11 et représentent la structure obtenue après le dépôt de la couche 68, utilisée comme masque de gravure, sur l'ensemble de la structure et, à chaque emplacement souhaité d'un mur 38, la gravure d'une ouverture 70 dans la couche 68, éventuellement d'une ouverture 80 dans la couche 62 prolongeant l'ouverture 70, d'une ouverture 81 dans la couche 54 prolongeant l'ouverture 70, et la gravure de l'ouverture 72, prolongeant l'ouverture 70, dans la couche transparente 50 sur la totalité de l'épaisseur de la couche transparente 50.

La figure 21 représente la structure obtenue après une étape de CMP pour retirer les couches isolantes 54, 62 et 68. Cette étape peut ne pas être présente.

La figure 22 représente la structure obtenue après des étapes analogues aux étapes décrites précédemment en relation avec la figure 13 et comprenant le dépôt, sur la totalité de la structure représentée en figure 21, de la couche isolante 76 dans le matériau composant les revêtements 42 des murs 38 et après le remplissage des ouvertures 72 par le matériau composant les coeurs 40 des murs 38, ce qui entraîne la formation de la couche 78 du matériau de remplissage sur les blocs 32, 33, 34.

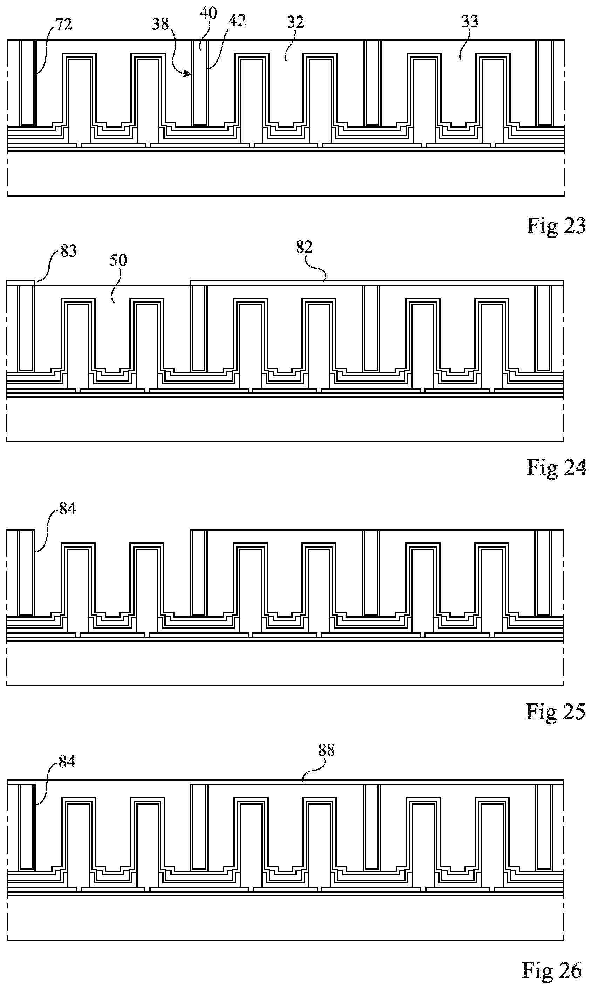

La figure 23 représente la structure obtenue après une étape de CMP ou de gravure sèche pour retirer la couche 78 du matériau de remplissage et les parties de couche 76 situées en dehors des ouvertures 72 jusqu'à exposer les parties de la couche isolante 37 recouvrant les couches isolantes 36, délimitant ainsi les murs 38.

La figure 24 représente la structure obtenue après le dépôt d'une couche 82, utilisée comme masque de gravure, sur l'ensemble de la structure et, à chaque emplacement souhaité d'un bloc photoluminescent d'un troisième type, la gravure d'une ouverture 83 dans la couche 82.

La figure 25 représente la structure obtenue après la gravure d'une ouverture 84, prolongeant l'ouverture 82 dans la couche transparente 50 sur la totalité de l'épaisseur de la couche transparente 50 et après avoir retiré la couche 80.

La figure 26 représente la structure obtenue après avoir rempli complètement les ouvertures 84 avec le matériau formant les blocs photoluminescents du troisième type. Il peut s'agir d'un dépôt à la tournette. L'étape de remplissage entraîne la formation d'une couche 88 du matériau formant les blocs photoluminescents sur le reste de la structure en dehors des ouvertures 84.

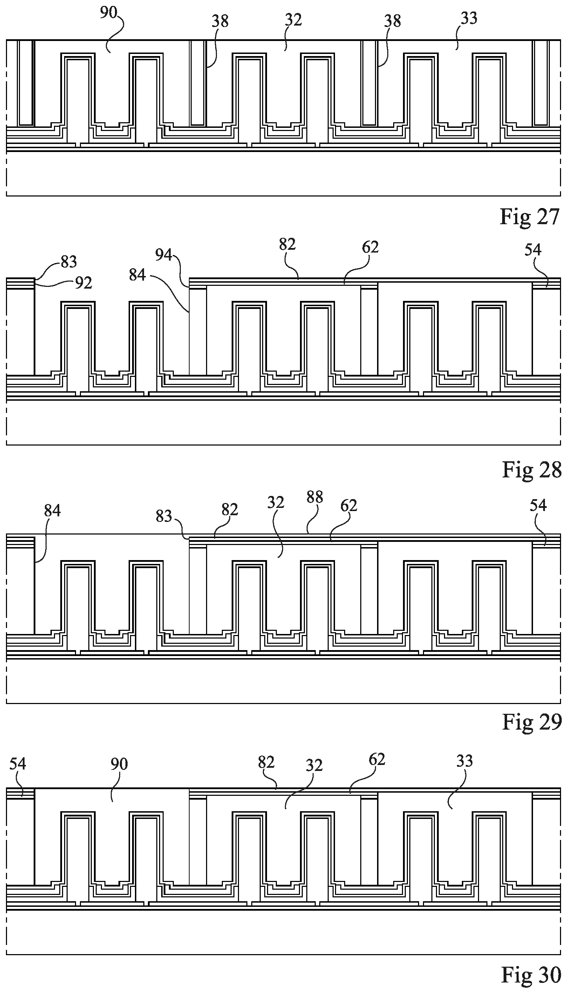

La figure 27 représente la structure obtenue après une étape de CMP pour retirer la couche 88. Des blocs photoluminescents 90 du troisième type sont ainsi délimités. Dans le cas où il n'y a pas de blocs transparents 34, tels que décrits précédemment, recouvrant des diodes électroluminescentes DEL, il n'est pas nécessaire que la couche 50 soit en un matériau fortement transparent, dans la mesure où il n'y a plus de portions de cette couche 50 recouvrant des diodes électroluminescentes à la fin du procédé de fabrication.

Le procédé comprend des étapes supplémentaires de formation des filtres de couleur 44 et de la couche de protection 46.

Les figures 28 à 31 illustrent les structures obtenues à des étapes successives d'un autre mode de réalisation d'un procédé de fabrication du dispositif optoélectronique 5.

Les étapes initiales du procédé comprennent l'ensemble des étapes décrites précédemment en relation avec les figures 3 à 18.

La figure 28 représente la structure obtenue après le dépôt de la couche 82, utilisée comme masque de gravure, sur l'ensemble de la structure et, à chaque emplacement souhaité d'un bloc photoluminescent 90 du troisième type, la gravure de l'ouverture 83 dans la couche 82, d'une ouverture 92 dans la couche 62 prolongeant l'ouverture 83, d'une ouverture 94 dans la couche 54 prolongeant l'ouverture 83, et la gravure de l'ouverture 84, prolongeant l'ouverture 83 dans la couche 50 sur la totalité de l'épaisseur de la couche 50.

La figure 29 représente la structure obtenue après avoir rempli complètement les ouvertures 84 avec le matériau formant les blocs photoluminescents 90 du troisième type. Il peut s'agir d'un dépôt à la tournette. L'étape de remplissage entraîne la formation de la couche 88 du matériau formant les blocs photoluminescents 90 sur le reste de la structure en dehors des ouvertures 84.

La figure 30 représente la structure obtenue après une étape de CMP pour retirer la couche 88. Les blocs photoluminescents 90 du troisième type sont ainsi délimités.

Dans les modes de réalisation décrits précédemment, les étapes de formation d'ouvertures 58, 66, 84 dans la couche 50 comprennent l'utilisation de masques de gravure. Selon un autre mode de réalisation, les étapes de gravure des ouvertures dans la couche 50 peuvent directement être réalisées par des étapes de photolithographie lorsque la couche 50 est en une résine photosensible.

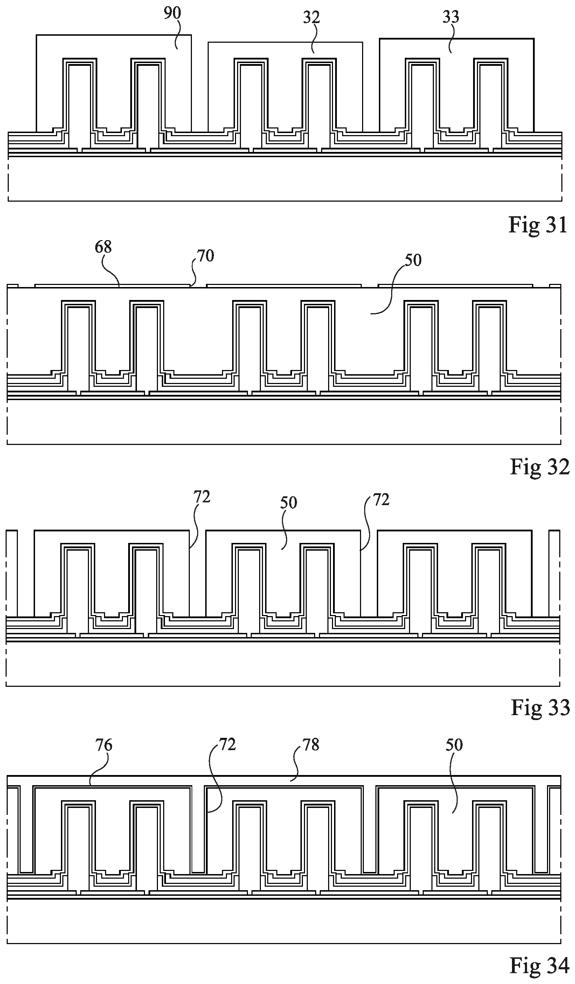

La figure 31 représente la structure obtenue après une étape de gravure sélective pour retirer les couches de masque 54, 62, 82 et retirer les portions de la couche transparente 50 demeurant entre les blocs photoluminescents 32, 33, 90.

Le procédé peut comprendre ensuite les étapes décrites précédemment en relation avec les figures 13 et 14, notamment pour la formation des murs 38 dans les ouvertures libérées entre les blocs photoluminescents 32, 33, 90.

Les figures 32 à 39 illustrent les structures obtenues à des étapes successives d'un autre mode de réalisation d'un procédé de fabrication du dispositif optoélectronique 5.

Les étapes initiales du procédé comprennent l'ensemble des étapes décrites précédemment en relation avec la figure 3.

La figure 32 représente la structure obtenue après le dépôt de la couche 68, utilisée comme masque de gravure, sur la couche transparente 50 et, à chaque emplacement souhaité d'un mur 38, la gravure d'une ouverture 70 dans la couche 68.

La figure 33 représente la structure obtenue après la gravure de l'ouverture 72, prolongeant chaque ouverture 70, dans la couche transparente 50 sur la totalité de l'épaisseur de la couche transparente 50.

La figure 34 représente la structure obtenue après des étapes analogues aux étapes décrites précédemment en relation avec la figure 13 et comprenant le dépôt, sur la totalité de la structure représentée en figure 33 de la couche isolante 76 dans le matériau composant les revêtements 42 des murs 38, et après le remplissage des ouvertures 72 par le matériau composant les coeurs 40 des murs 38, ce qui entraîne la formation de la couche 78 du matériau de remplissage sur la couche transparente 50.

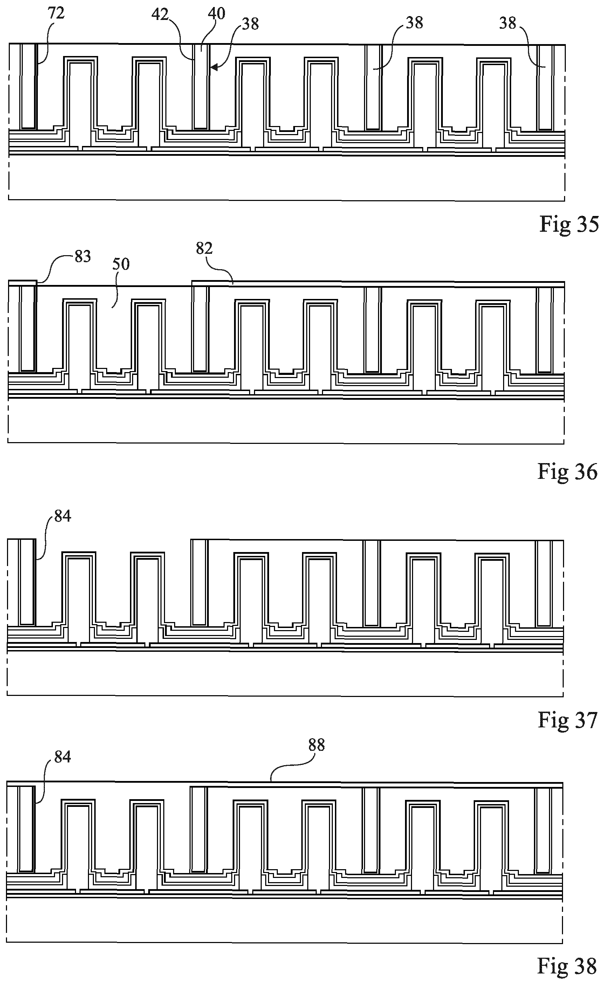

La figure 35 représente la structure obtenue après une étape de gravure pour retirer la couche 78 du matériau de remplissage et les parties de couche 76 situées en dehors des ouvertures 72, délimitant ainsi les murs 38. Comme cela a été décrit précédemment, les parties de la couche 78 en dehors des ouvertures 72 peuvent être retirées par gravure sèche ou CMP et les parties de la couche 76 situées en dehors des ouvertures 72 peuvent être retirées par gravure humide ou sèche.

Les figures 36 à 39 représentent les structures obtenues aux étapes décrites précédemment en relation avec respectivement les figures 24 à 27 et conduisent à la formation des blocs 32 photoluminescents du premier type. Ces étapes sont répétées une fois pour la formation des blocs 33 photoluminescents du deuxième type et éventuellement une fois pour la formation des blocs 90 photoluminescents du troisième type.

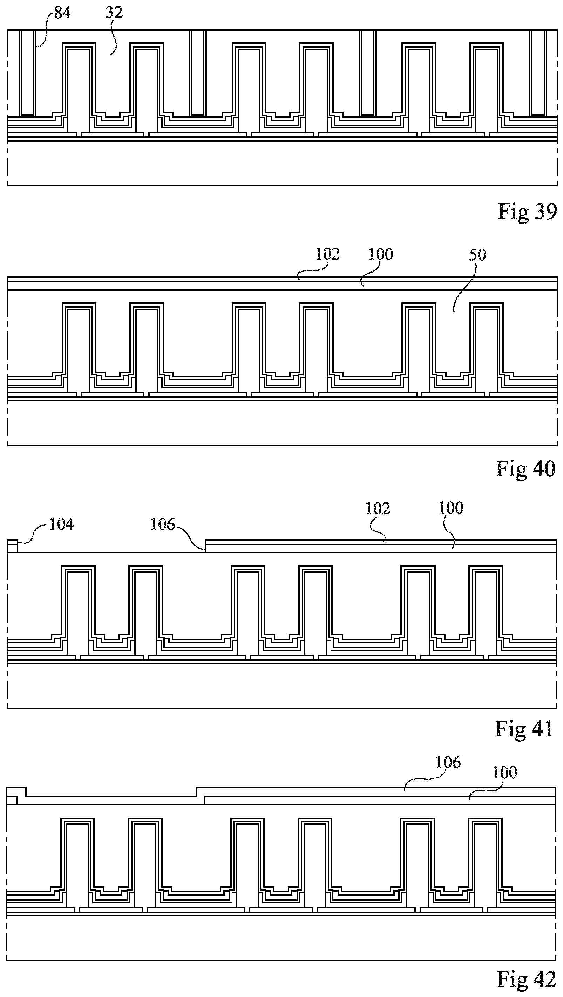

Les figures 40 à 52 illustrent les structures obtenues à des étapes successives d'un autre mode de réalisation d'un procédé de fabrication du dispositif optoélectronique 5.

Les étapes initiales du procédé comprennent l'ensemble des étapes décrites précédemment en relation avec la figure 3.

La figure 40 représente la structure obtenue après le dépôt d'une couche 100, utilisée comme masque de gravure, et recouvrant la couche transparente 50, et d'une couche 102 d'une résine photosensible recouvrant la couche 100. La couche 100 peut être dans l'un des matériaux décrits précédemment pour la couche isolante 18, 24, 30, 36, 37, 46.

La figure 41 représente la structure obtenue après la gravure d'une ouverture 104 dans la couche 102 et d'une ouverture 106, prolongeant l'ouverture 104, dans la couche 100 à chaque emplacement souhaité d'un bloc photoluminescent 32 du premier type.

La figure 42 représente la structure obtenue après le retrait de la couche 102 de résine photosensible et le dépôt d'une couche isolante 106 sur l'ensemble de la structure. La couche 106 peut être dans l'un des matériaux décrits précédemment pour la couche isolante 18, 24, 30, 36, 37, 46.

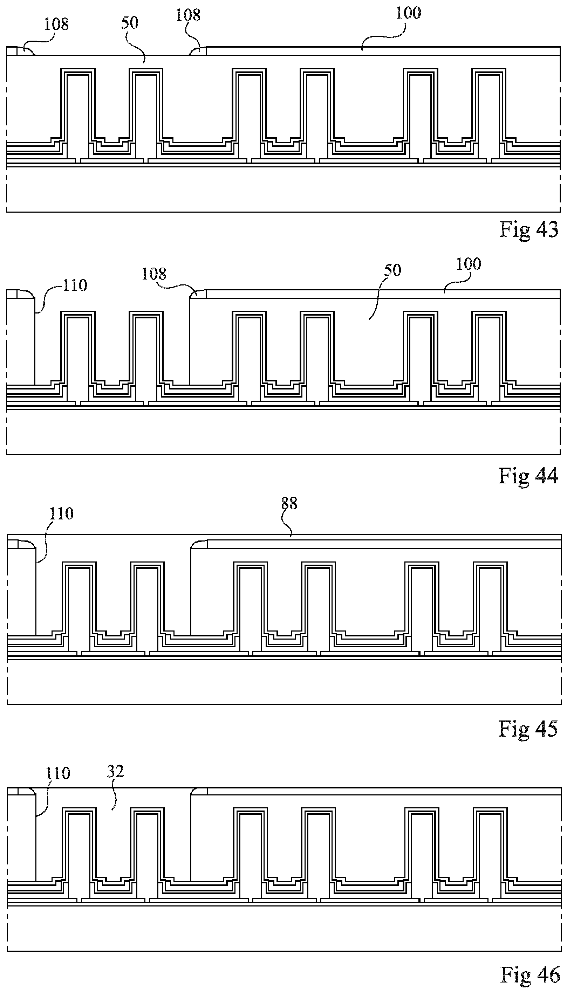

La figure 43 représente la structure obtenue après une gravure de la couche isolante 106 entraînant la formation de portions 108 de la couche isolante 106, appelés espaceurs, sur les flancs de chaque ouverture 104 et le retrait de la couche isolante 106 par ailleurs. La gravure peut être une gravure sèche.

La figure 44 représente la structure obtenue après la gravure d'une ouverture 110, dans la couche transparente 50 sur la totalité de l'épaisseur de la couche transparente 50, l'ouverture 110 étant délimitée par le masque formé par la couche 100 et les espaceurs 108.

La figure 45 représente la structure obtenue après avoir rempli complètement les ouvertures 110 avec le matériau formant les blocs photoluminescents 32 du premier type. Il peut s'agir d'un dépôt à la tournette. L'étape de remplissage entraîne la formation de la couche 88 du matériau formant les blocs photoluminescents 32 sur le reste de la structure en dehors des ouvertures 110.

La figure 46 représente la structure obtenue après une étape de CMP pour retirer la couche 88. Les blocs photoluminescents 32 du premier type sont ainsi délimités.

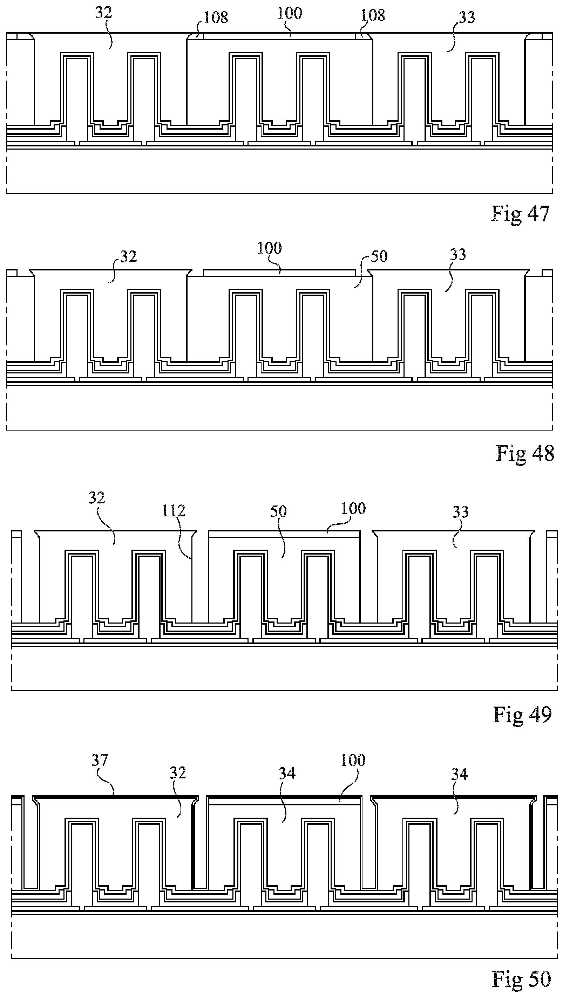

La figure 47 représente la structure obtenue après avoir répété les étapes décrites précédemment en relation avec les figures 40 à 45 pour la délimitation des blocs photoluminescents 33 du deuxième type.

La figure 48 représente la structure obtenue après avoir retiré les espaceurs 108, par exemple par une gravure sélective par rapport aux matériaux composant les blocs photoluminescents 32, 33, au matériau composant la couche transparente 50 et au matériau composant la couche isolante 100. Il peut s'agir d'une gravure sèche ou d'une gravure humide.

La figure 49 représente la structure obtenue après avoir gravé des ouvertures 112 dans la couche transparente 50, dans le prolongement des ouvertures formées par le retrait des espaceurs 108, sur toute l'épaisseur de la couche transparente 50.

La figure 50 représente la structure obtenue après le dépôt, sur la totalité de la structure représentée en figure 5, de la couche isolante 37.

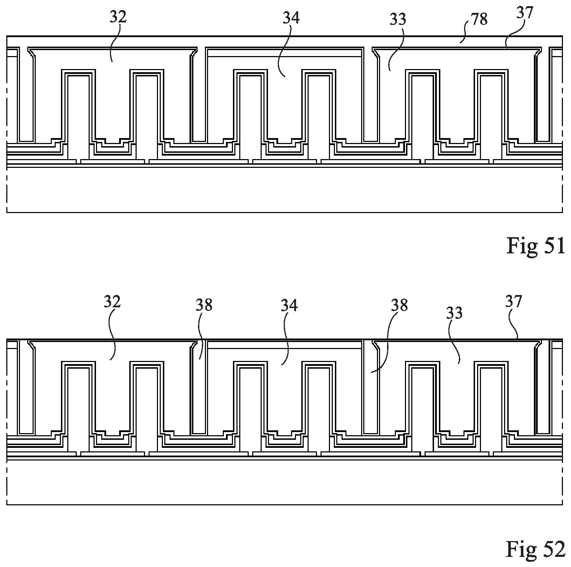

La figure 51 représente la structure obtenue après le remplissage des ouvertures 102 par le matériau composant les coeurs 40 des murs 38 ce qui entraîne la formation de la couche 78 du matériau de remplissage sur les blocs 32, 33, 34.

La figure 52 représente la structure obtenue après une étape de CMP pour retirer la couche 78 du matériau de remplissage et les parties de couche 76 situées en dehors des ouvertures 112 jusqu'à exposer les parties de la couche isolante 37 recouvrant les faces supérieures des blocs 32, 33, 34, délimitant ainsi les murs 38.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les procédés de fabrication des dispositifs optoélectroniques peuvent comprendre des étapes supplémentaires qui n'ont pas été décrites, par exemple le report de la structure sur des supports intermédiaires, également appelés poignées, pour en permettre la manipulation. Enfin, la mise en oeuvre pratique des modes de réalisation et variantes décrits est à la portée de l'homme du métier à partir des indications fonctionnelles données ci-dessus.

## Revendications

1. Procédé de fabrication d'un dispositif optoélectronique (5) comprenant des ensembles de diodes électroluminescentes (DEL) dont des premiers et deuxièmes ensembles et des premiers blocs (32) en un premier matériau photoluminescent recouvrant chacun l'un des premiers ensembles, le procédé comprenant la formation d'une couche (50) recouvrant les premiers et deuxièmes ensembles, la délimitation de premières ouvertures (58) dans la couche (50) pour exposer les premiers ensembles, le remplissage des premières ouvertures (58) du premier matériau photoluminescent et la réalisation d'un polissage mécano-chimique pour délimiter les premiers blocs (32), dans lequel le dispositif comprend des deuxièmes blocs (33) en un deuxième matériau photoluminescent, différent du premier matériau photoluminescent, recouvrant chacun l'un des deuxièmes ensembles, le procédé comprenant la délimitation de deuxièmes ouvertures (66) dans la couche (50) pour exposer les deuxièmes ensembles, le remplissage des deuxièmes ouvertures (66) du deuxième matériau photoluminescent et la réalisation d'un polissage mécano-chimique pour délimiter les deuxièmes blocs (33).

2. Procédé selon la revendication 1, dans lequel le dispositif comprend en outre des troisièmes ensembles de diodes électroluminescentes (DEL) et des troisièmes blocs (90) en un troisième matériau photoluminescent, différent des premier et deuxième matériaux photoluminescents, recouvrant chacun l'un des troisièmes ensembles, le procédé comprenant la délimitation de troisièmes ouvertures (84) dans la couche (50) pour exposer les troisièmes ensembles, le remplissage des troisièmes ouvertures du troisième matériau et la réalisation d'un polissage mécano-chimique pour délimiter les troisièmes blocs.

3. Procédé selon la revendication 1 ou 2, dans lequel le dispositif comprend en outre des quatrièmes ensembles de diodes électroluminescentes (DEL), le procédé comprenant la délimitation de quatrièmes blocs (34) dans la couche (50) recouvrant chacun l'un des quatrièmes ensembles de diodes électroluminescentes.

4. Procédé selon la revendication 3, dans lequel la couche (50) est au moins partiellement transparente au rayonnement émis par les diodes électroluminescentes (DEL) des quatrièmes ensembles de diodes électroluminescentes.

5. Procédé selon l'une quelconque des revendications 1 à 4, comprenant la délimitation de quatrièmes ouvertures (72) dans la couche (50) entre les ensembles de diodes électroluminescentes (DEL) et la formation de murs (38) aux parois réfléchissantes dans les quatrièmes ouvertures.

6. Procédé selon la revendication 5, comprenant le dépôt d'un revêtement réfléchissant (42) dans les quatrièmes ouvertures (72) et le remplissage du reste des quatrièmes ouvertures par un cinquième matériau.

7. Procédé selon la revendication 5, dans lequel les murs (38) sont formés après les premiers blocs photoluminescents (32).

8. Procédé selon la revendication 7, comprenant la formation d'une couche barrière (37) s'étendant dans les quatrièmes ouvertures (72) et recouvrant les premiers blocs photoluminescents (32) avant la formation des murs (38).

9. Procédé selon la revendication 6, dans lequel les murs (38) sont formés après les premiers et deuxièmes blocs photoluminescents (32, 33).

10. Procédé selon la revendication 5, dans lequel les murs (38) sont formés avant les premiers et deuxièmes blocs photoluminescents (32, 33).

11. Procédé selon la revendication 5 dans son rattachement à la revendication 2, comprenant la gravure de la couche (50) présente entre les premiers, deuxièmes et troisièmes blocs photoluminescents (32, 33, 90), la formation d'une couche barrière (37) s'étendant dans les quatrièmes ouvertures (72) et recouvrant les premiers, deuxièmes et troisièmes blocs photoluminescents (32, 33, 90) avant la formation des murs (38) et la formation des murs (38) dans les espaces présents entre les premiers, deuxièmes et troisièmes blocs photoluminescents (32, 33, 90).

## Patentansprüche

1. Verfahren zur Herstellung einer optoelektronischen Vorrichtung (5), die Anordnungen aus Leuchtdioden (DEL) mit ersten und zweiten Anordnungen und ersten Blöcken (32) aus einem ersten photolumineszierenden Material aufweist, die jeweils eine der ersten Anordnungen bedecken, wobei das Verfahren Folgendes aufweist, das Ausbilden einer Schicht (50), die die ersten und zweiten Anordnungen bedeckt, das Begrenzen erster Öffnungen (58) in der Schicht (50) zum Freilegen der ersten Anordnungen, das Füllen der ersten Öffnungen (58) mit dem ersten photolumineszierenden Material und das Durchführen eines chemisch-mechanischen Polierens zum Begrenzen der ersten Blöcke (32), wobei die Vorrichtung zweite Blöcke (33) aus einem zweiten photolumineszierenden Material aufweist, das sich vom ersten photolumineszierenden Material unterscheidet, wobei die zweiten Blöcke jeweils eine der zweiten Anordnungen bedecken, wobei das Verfahren ferner aufweist, das Begrenzen zweiter Öffnungen (66) in der Schicht (50), um die zweiten Anordnungen freizulegen, das Füllen der zweiten Öffnungen (66) mit dem zweiten photolumineszierenden Material und das Durchführen eines chemisch-mechanischen Polierens, zum Begrenzen der zweiten Blöcke (33).

2. Verfahren nach Anspruch 1, wobei die Vorrichtung ferner dritte Anordnungen aus Leuchtdioden (DEL) und dritte Blöcke (90) aufweist, die aus einem dritten photolumineszierenden Material bestehen, das sich von dem ersten und zweiten photolumineszierenden Material unterscheidet, wobei jeder Block eine der dritten Anordnungen abdeckt, wobei das Verfahren aufweist, das Begrenzen dritter Öffnungen (84) in der Schicht (50), um die dritten Anordnungen freizulegen, das Füllen der dritten Öffnungen mit dem dritten Material und das Durchführen eines chemisch-mechanischen Polierens zum Begrenzen der dritten Blöcke.

3. Verfahren nach Anspruch 1 oder 2, wobei die Vorrichtung ferner vierte Anordnungen von Leuchtdioden (DEL) aufweist, wobei das Verfahren das Begrenzen von vierten Blöcken (34) in der Schicht (50) aufweist, die jede der vierten Anordnungen von Leuchtdioden bedeckt.

4. Verfahren nach Anspruch 3, wobei die Schicht (50) zumindest teilweise für die von den Leuchtdioden (DEL) der vierten Anordnungen emittierte Strahlung durchlässig ist.

5. Verfahren nach einem der Ansprüche 1 bis 4, aufweisend das Begrenzen von vierten Öffnungen (72) in der Schicht (50) zwischen den Anordnungen von Leuchtdioden (DEL) und das Ausbilden von Wänden (38) mit reflektierenden Seiten in den vierten Öffnungen.

6. Verfahren nach Anspruch 5, aufweisend das Abscheiden einer reflektierenden Beschichtung (42) in den vierten Öffnungen (72) und das Füllen des Rests der vierten Öffnungen mit einem fünften Material.

7. Verfahren nach Anspruch 5, wobei die Wände (38) nach den ersten photolumineszierenden Blöcken (32) gebildet werden.

8. Verfahren nach Anspruch 7, aufweisend das Ausbilden einer Barriereschicht (37), die sich in den vierten Öffnungen (72) erstreckt und die ersten photolumineszierenden Blöcke (32) bedeckt, und zwar vor dem Ausbilden der Wände (38).

9. Das Verfahren nach Anspruch 6, wobei die Wände (38) nach den ersten und zweiten photolumineszierenden Blöcken (32, 33) ausgebildet werden.

10. Das Verfahren nach Anspruch 5, wobei die Wände (38) vor den ersten und zweiten photolumineszierenden Blöcken (32, 33) ausgebildet werden.

11. Verfahren nach Anspruch 5 und nach Anspruch 2, aufweisend das Ätzen der zwischen dem ersten, zweiten und dritten photolumineszierenden Blöcken (32, 33, 90) vorhandenen Schicht (50), das Ausbilden einer Barriereschicht (37), die sich in die vierten Öffnungen (72) erstreckt und die ersten, zweiten und dritten photolumineszierenden Blöcke (32, 33, 90) bedeckt, und zwar vor dem Ausbilden der Wände (38), und das Ausbilden der Wände (38) in zwischen den ersten, zweiten und dritten photolumineszierenden Blöcken (32, 33, 90) vorhandenen Zwischenräumen.

## Claims

1. A method of manufacturing an optoelectronic device (5) comprising assemblies of light-emitting diodes (DEL) having first and second assemblies and first blocks (32) made of a first photoluminescent material, each covering one of the first assemblies, the method comprising forming a layer (50) covering the first and second assemblies, delimiting first openings (58) in the layer (50) to expose the first assemblies, filling the first openings (58) with the first photoluminescent material, and performing a chemical-mechanical polishing to delimit the first blocks (32), wherein the device comprises second blocks (33) made of a second photoluminescent material, different from the first photoluminescent material, each covering one of the second assemblies, the method comprising delimiting second openings (66) in the layer (50) to expose the second assemblies, filling the second openings (66) with the second photoluminescent material, and performing a chemical-mechanical polishing to delimit the second blocks (33).

2. The method according to claim 1, wherein the device further comprises third assemblies of light-emitting diodes (DEL) and third blocks (90) made of a third photoluminescent material, different from the first and second photoluminescent materials, each covering one of the third assemblies, the method comprising delimiting third openings (84) in the layer (50) to expose the third assemblies, filling the third openings with the third material, and performing a chemical-mechanical polishing to delimit the third blocks.

3. The method according to claim 1 or 2, wherein the device further comprises fourth assemblies of light-emitting diodes (DEL), the method comprising delimiting fourth blocks (34) in the layer (50) covering each of the fourth assemblies of light-emitting diodes.

4. The method according to claim 3, wherein the layer (50) is at least partially transparent to the radiation emitted by the light-emitting diodes (DEL) of the fourth assemblies of light-emitting diodes.

5. The method according to any of claims 1 to 4, comprising delimiting fourth openings (72) in the layer (50) between the assemblies of light-emitting diodes (DEL) and forming walls (38) with reflective sides in the fourth openings.

6. The method according to claim 5, comprising depositing a reflective coating (42) in the fourth openings (72) and filling the rest of the fourth openings with a fifth material.

7. The method according to claim 5, wherein the walls (38) are formed after the first photoluminescent blocks (32).

8. The method according to claim 7, comprising forming a barrier layer (37) extending in the fourth openings (72) and covering the first photoluminescent blocks (32) before the forming of the walls (38).

9. The method according to claim 6, wherein the walls (38) are formed after the first and second photoluminescent blocks (32, 33).

10. The method according to claim 5, wherein the walls (38) are formed before the first and second photoluminescent blocks (32, 33).

11. The method according to claim 5 and according to claim 2, comprising etching the layer (50) present between the first, second, and third photoluminescent blocks (32, 33, 90), forming a barrier layer (37) extending in the fourth openings (72) and covering the first, second, and third photoluminescent blocks (32, 33, 90) before the forming of the walls (38), and forming the walls (38) in the spaces present between the first, second, and third photoluminescent blocks (32, 33, 90).
